(19) Europäisches Patentamt
European Patent Office
Office européen des brevets

(11) Publication number: **0 153 133 B1**

(12) # EUROPEAN PATENT SPECIFICATION

(45) Date of publication of patent specification: **04.12.91**

(51) Int. Cl.$^5$: **B05D 1/00**, B05D 1/18, B03D 3/06, B05D 7/02, B05D 7/04, B05D 7/00, G03C 5/00, C03C 17/00, C08J 7/00

(21) Application number: **85300919.9**

(22) Date of filing: **12.02.85**

(54) **Assembling multilayers of polymerizable surfactant on a surface of a solid material.**

(30) Priority: **13.02.84 US 579386**

(43) Date of publication of application:
**28.08.85 Bulletin 85/35**

(45) Publication of the grant of the patent:
**04.12.91 Bulletin 91/49**

(84) Designated Contracting States:
**CH DE FR GB IT LI SE**

(56) References cited:
**GB-A- 1 447 000**
**US-A- 4 485 045**

**SOLID STATE TECHNOLOGY, vol. 22, no. 8, August 1979, pages 120-134; A. BARRAUD et al.: "Monomolecular resists: A new class of high resolution resists for electron beam microlithography"**

**ANGEWANDTE CHEMIE INT. ED. ENGL., vol. 20, 1981, pages 305-325, Verlag Chemie GmbH, Weinheim, DE; L. GROS et al.: "Polymeric antitumor agents on a molecular and on a cellular level?"**

(73) Proprietor: **MARQUETTE UNIVERSITY**
**615, North 11th Street**
**Milwaukee Wisconsin(US)**

(72) Inventor: **Regen, Steven Louis**
**8451 Greenvale Road**
**Milwaukee Wisconsin(US)**

(74) Representative: **Baillie, Iain Cameron et al**
**c/o Ladas & Parry Isartorplatz 5**
**W-8000 München 2(DE)**

EP 0 153 133 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention is directed to modifying the surfaces of solid materials and, more particularly, to methods of assembling multiple polymeric layers (multilayers) of polymerizable surfactant directly on the surface of solid materials.

Surface structure and composition play a significant role in defining many of the physical properties and ultimate uses of solid materials. In particular, features such as wetting, weathering, adhesion, dye adsorption, friction, electrostatic charging, permeation, and biocompatibility are largely influenced by surface characteristics. The alteration of surface characteristics can, therefore, be significant for engineering and biotechnological applications. The methods which are currently available, however, for modifying, in a well-defined manner, solid surfaces, and especially for modifying polymer surfaces, remain limited.

It is, therefore, desirable to provide alternative means of modifying the surface characteristics of solids, particularly those having configurations which are difficult, if not impossible, to coat by conventional processes. Particularly, it would be desirable to provide a method for assembling polymerized multilayers of polymerizable materials directly onto the surfaces of solid substrates having complex configurations. Various conventional methods exist for assembling multilayers such as those disclosed in the following literature references, Blodgett, K.B., J. Am. Chem. Soc., 1935, Vol. 57, page 1007; Blodgett, K.B. Langmuir, I., Phys. Rev., 1937, Vol. 51, page 964; Gaines, G.L., Jr., Thin Solid Films, 1980, Vol. 68, page 1; Honig, E.P.I., J. Colloid Interface Sci., 1973, Vol. 43, page 66; Kopp, F., Fringeli, U.P., Muhlethaler, K., Gunthard, H., Biophys. Struct. Mech., 1975, Vol. 1, page 75; and Sagiv. J. and Netzer, L., J. Am. Chem. Soc., 1983, Vol. 105, page 674; which show various methods and materials for modifying solid surfaces. The methods disclosed in these references have certain limitations especially when applied in large scale operations, and/or when applied to substrates having complex configurations.

The need exists, therefore, for new methods for modifying solid surfaces, and especially organic polymer surfaoes, and more particularly surfaces having complex configurations. Particularly promising materials for modifying the surfaces of solid materials are polymerizable surfactants. Some polymerizable surfactants are disclosed in US 4,485,045 (Regen).

US 4,485,045 discloses a class of synthetic phosphatidyl derivatives which can form vesicles by being polymerized in situ. Particularly, it discloses use of synthetic phosphatidyl- cholines for such purposes. The phosphatidylcholine compounds disclosed therein can be used to modify the surfaces of solid organic polymers such as polyethylene by polymerization on the surface thereof.

US 4,485,045 discloses forming a monolayer of polymer (lipid) on a surface of a hydrophobic olefinic polymer. Useful lipids include the phosphatidylcholine compounds disclosed therein as well as amphiphylic lipids having an olefinic polymerizable substituent. A large number of amphiphylic lipids having an olefinic polymerizable substituent are described in the paper of Hub, et al., Angewandte Chemie, (English edition) Vol. 19, (1981), page 938; and in

"Polymerization of Organized Surfactant Assemblies," J.H. Fender, in "Surfactants in Solution," Edited by K.L. Mittal and B. Lindham, Plenum Press. New York, 1984, pages 1947 to 1989;

"Polymerized Surfactant Aggregates:
Characterization and Utilization," J.H. Fendler and P. Tundo, Accounts Chem. Res., Volume 17, Pages 3 to 8, (1984); and

"Polymerized Surfactant Vesicles - Novel Membrane Mimetic Systems, Science, Volume 223, pages 888 to 894, (1984).

The need exists, therefore, to develop methods for assembling multilayers of polymerizable surfactants on surfaces of solid substrates, particularly surfaces of solid organic polymers, and most particularly such surfaces as are present in articles having complex configurations, in order to modify the surface characteristics of these materials.

The paper "Monomolecular Resists: A New Class of High Resolution Resists for Electron Beam Microlithography" by A. Barraud, C. Rosilio and A. Ruaudel-Teixier, 400 Solid State Technology, Vol. 22 (1979) Aug. No. 8, discloses substrates comprising several layers each layer consisting of a single layer of amphiphilic (i.e. both hydrophilic and hydrophobic) molecules.

GB 1,447,000 discloses a process for the preparation of a single layer film comprising cross-linking a surface layer of a coating of surfactant by irradiation with a plasma or ionising radiation. The un-crosslinked portions of the surfactant beneath the surface of the coating are dissolved away in water, to leave a single layer film on the water surface.

The present invention relates to a method for the stepwise coating of a solid substrate with a polyfunctional polymerizable surfactant to provide a multilayer assembly on a surface of the solid substrate comprising depositing and polymerizing sequential layers of polymerizable surfactant on said substrate or

coated substrate from a polymerization system comprising (a) a polyfunctional polymerizable surfactant in an aqueous or polar solvent system; and (b) a polyfunctional polymerizable surfactant in non-polar organic solvent system; wherein the sequential coatings are alternately effected from the (a) and (b) polymerization systems and polymerizable surfactant utilized is the same or different for each sequential coating.

In preferred embodiments, the polymerizing step is effected by irradiation. The aqueous or other polar solvent of such polymerization system (a) need not be removed prior to polymerization, and is usually present during the polymerization step. The non-polar organic solvent of such polymerization system (b) is usually removed prior to the polymerization step, but need not be. The invention includes a substrate having directly deposited thereon a multilayer assembly formed from a plurality of oriented monolayers of polymerized surfactant.

The invention also comprises the multilayered surfactant coated solid substrates produced by the method of the invention. In addition, the invention relates to an isolated surfaced article having deposited on some or all of the isolated surfaces thereof a multilayer assembly formed from a plurality of polymerized oriented monolayers of polymerizable surfactant.

Reference will now be made in detail to the present preferred embodiments of the method of the invention and the products produced thereby.

The invention provides a method for assembling polymerized multilayers of polymerizable surfactant on a surface of a solid material. The solid materials contemplated by the invention include, but are not limited to, organic polymers, glass, silanated glass, graphite, and metals. Particularly preferred materials include $C_2$ to $C_8$ olefin homopolymers and copolymers and, more particularly, homopolymers such as polyethylene, polypropylene, polybutylene and polystyrene and copolymers such as copolymers of ethylene and one or more $C_3$ to $C_8$ olefins, and mixtures of such polymers.

The term silanated glass means glass that has had its surface treated with a silicon compound such as a silicone, a silicon ether or ester or a silylating agent.

The solid substrates may be either hydrophobic or hydrophilic. They may have simple planar surfaces such as film, continuous film, block or strip form. The substrates may also have highly irregular or complex shaped surfaces which are not readily, if at all, coatable by the prior art processes. The configurations of substrates that may be completely coated, for example, by the well known Langmuir-Blodgett prior art process are very limited, and will not include articles having one or more isolated surfaces. Such isolated surfaces will not be coated when employing the Langmuir Blodgett Process. An isolated surfaced object, therefore, for the purpose of the present invention is one having a configuration such that, when lowered, at any angle or orientation, into a Langmuir-Blodgett coating bath, the object has one or more surfaces which become, and remain, isolated from the surface pressure maintained by the coating film balance in the coating bath. Various types of isolated surfaced objects, therefore, are not coatable by the Langmuir-Blodgett process, such as, tubing, porous materials, woven and non woven constructions and rough surfaced articles.

A rough surfaced article is one which has a projected surface area that is a fraction, i.e., a 1/10 to 1/2, of the actual surface area as determined, for example, by surface adsorption studies.

Other types of articles that are difficult or impossible to coat in the Langmuir-Blodgett process are fine, particulate sized materials, whether porous or not, that would have a particle size of the order of about 100 micrometers or less.

When coating surfaces with surfactant in the Langmuir-Blodgett process the surfactant layer is not directly applied to the surface being coated. In the Langmuir-Blodgett process the surfactant layer is floated or transferred to the substrate being coated; and the surfactant layer to be transferred is established at an interface of, say, air and water or air and mercury. When an air/water interface is used in the Langmuir Blodgett Process the interface tension is 727.5 mN/m (72.75 dynes/cm) at 20° C., where the surface tension of air is zero dynes/cm. When an air/mercury interface is used in the Langmuir Blodgett process the interface tension is 4355 mN/m (435.5 dynes/cm).

When using the process of the present invention, on the other hand, the substrate being coated with the surfactant is coated directly on the surfaces thereof by application thereto of a bulk solution of the surfactant being used, as by having the substrate immersed in a bulk solution of the surfactant, and the surfactant forms a coating directly on the surface of the substrate being coated. Thus, since a specific interfacial system, such as air/water, is not needed for the process of the present invention, the present invention allows for a much wider selection of interfacial tensions based on the surface tensions of the substrate (itself) being coated, and the medium (surfactant solution) in which the substrate is to be modified by coating.

The shaped articles that may be coated in the process of the present invention, and which are not coatable in the Langmuir-Blodgett process, may also be described as having no retrosurfaces, that is they

have a non-air occluding topography. Such articles or objects have one or more surfaces which are not coatable by the mechanical pressurized transfer of coating which is used in the Langmuir-Blodgett process. This mechanical pressurized transfer process requires the use of an air/water interface or at interface of air and another suitable liquid, such as mercury, at the precise location of the substrate surface which is to be coated.

Another type of substrate which can be coated in accordance with the invention is a planar material such as a solid organic polymer film which can have hydrophobic or hydrophilic surface characteristics. Such planar substrates would include organic polymer film in strip form or formed in a continuous manner. A continuous film is particularly adaptable for continuous assembly of polymerized surfactant layers thereon by running the film through an assembly line of steps for applying such polymerized surfactant layers as will be described herein.

When the coatings of polymerized surfactant are applied to the surface of the object being coated therewith, they may be applied so as to entirely coat the surfaces being coated, or the coatings may be used to form patterns on such surfaces such as in the form of a photoresist pattern, or a gridiron pattern, or a pattern of discontinuous symbols or figures such as dots, or other configurations in which less than the whole surface of the substrate is covered.

In order to effect such patterns on the surface of the object being coated suitably patterned photo masks may be used to block off from actinic radiation the areas which are to be coated.

The coatings of the present invention may also be applied to the substrate so as to provide coatings of different "heights" or thicknesses on different portions of the substrate. This may also be achieved by the use of masking means, i.e., after a coating of a given thickness is applied to a substrate, a portion of such first coating may be masked and the exposed remainder of the first coating can then be further coated with one or more additional coatings with or without the use of additional masks, at the higher coating levels, to optionally achieve additional patterns of coating heights or thicknesses in the subsequent coating levels.

A variation in this concept of providing coatings of different thicknesses, is to provide a series of stepped-up coatings, wherein each successive coating is superimposed on a portion, but not all, of the next lower coating, so that each upper level of coating is set back from the edge of the next lower coating.

Each layer of coating that is applied in accordance with the process of the present invention is typically about 2 to 5, and preferably about 3 to 4 nm (20 to 50, and preferably about 30 to 40 Angstroms) in thickness.

Types of planar or complex surfaced artioles on which the patterned coatings of the present invention may be advantageously applied would include substrates employing photoresists, non-linear optical elements for the purpose of fabricating optical devices such as switches, wave mixers and logical gates.

The surfaces of the solid materials when modified as disclosed above can have altered characteristics in terms of features such as wetting, weathering, adhesion, dye adsorption, friction, electrostatic charging, permeation and biocompatibility.

Suitable polymerizable surfactants include many conventional amphiphylic lipids having an olefinic polymerizable substituent such as those molecules described in the publications referred to above as well as any other polymerizable surfactants which are compatible with the method of the invention as would be known to those skilled in the art.

Polymerizable surfactant is defined, for the purposes of the present invention, as an amphiphathic molecule, that is, one having a hydrophilic portion and a hydrophobic portion, and the molecule also contains one or more polymerizable groups.

Preferred polymerizable surfactants in accordance with the methods of the invention are those containing two or more polymerizable groups within the molecule and will be defined for the purposes of the present invention and the appended claims as polyfunctional polymerizable surfactants. Surfactants containing only a single polymerizable group within the molecule (monofunctional) have, in limited experimentation, been found ineffective for modifying surfaces of low density polyethylene under the conditions employed for the present invention, e.g., the monofunctional phospholipid (A) and the monofunctional ammonium phosphate (B).

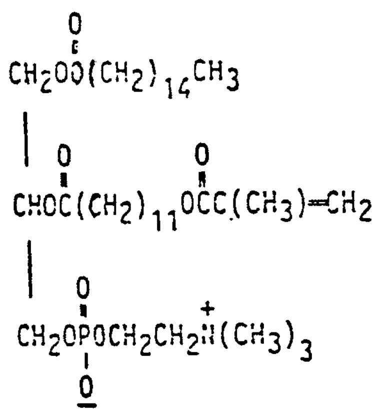

(A)

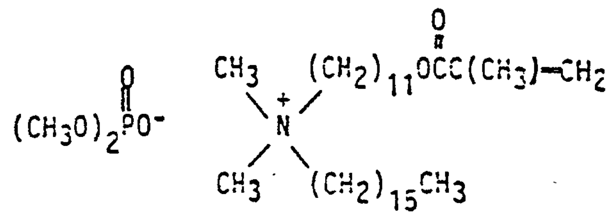

(B)

Particularly preferred polyfunctional polymerizable surfactants are those wherein at least two of the polymerizable groups are present in separate acid molecules of the lipid. These particularly preferred surfactants include phosphatidylcholines and, particularly, phosphatidyl cholines of the following structures:

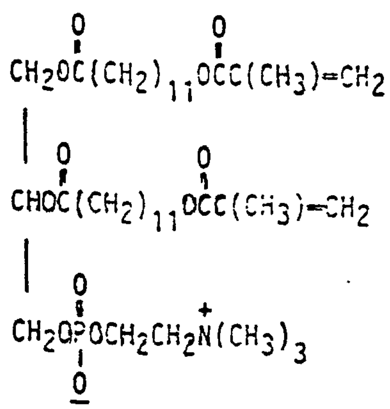

(I)

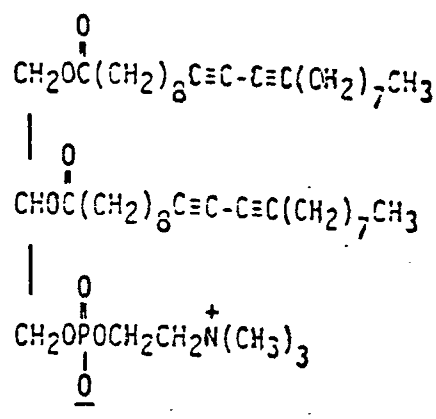

(II)

Also preferred are phosphate esters and ammonium phosphates and particularly a novel phosphate ester of the following structure:

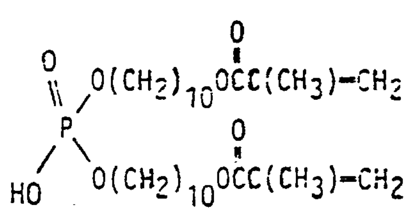

(III)

and a novel ammonium phosphate of the following structure:

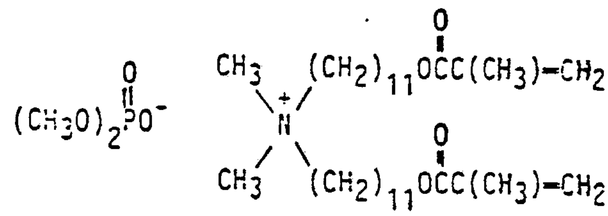

(IV)

In accordance with preferred embodiments of the invention, multilayers of polymerizable surfactant are assembled directly on the surface of a solid substrate by sequential deposition polymerization. The initial step is depositing a polyfunctional polymerizable surfactant on a surface of a solid substrate to form a coating of surfactant thereon. The polymerizable surfactant is deposited on the surface of the solid substrate in a polar solvent, preferably an aqueous solution, or in any suitable solvent which is evaporated from the surface to leave only the polymerizable surfactant on the surface.

The deposition of each coating of surfactant from its respective solvent system can be achieved by spontaneous deposition, as by immersing the substrate to be coated into a solution of the surfactant, or by treating the surface of the substrate with an aerosol formulation of the surfactant in its solvent, as by spraying the aerosol formulation on the substrate surface.

After polymerization of the first layer of surfactant a further layer of polyfunctional polymerizable surfactant in a non-polar solvent system is deposited directly on a substrate or on a previously coated substrate. Generally, the non-polar solvent system is substantially non-polar and aprotic but may contain minor amounts of polar and/or protic components.

Each coating of surfactant material on the surface of the solid material is polymerized to form an oriented mono-layer of polymerized surfactant on the surface of the substrate. The polymerization can be accomplished by either applying irradiation to the coating or by chemical means, preferably by utilizing a free radical initiator, to effect the polymerization. Suitable free radical initiators include peroxides and aliphatic azo compounds such as those described in Kirk-Othmer, *Encylopedia of Chemical Technology*, Vol. 13, "Initiators", pp. 355-371, 3rd ed., 1981.

Suitable non-polar solvents include conventional hydrocarbon solvents known to those skilled in the art. The non-polar solvent can be used in admixture with minor amounts of a polar solvent which is present in amounts to enhance the solubility of the polymerizable surfactant therein. Preferably, the non-polar solvent is a mixture of a major amount of *n*-hexadecane and a minor amount of a chloroform, preferably in a ratio of *n*-hexadecane to chloroform of about 100:1.

In preferred embodiments depositing a polymerizable surfactant in a polar solvent on a substrate with hydrophobic surface characteristics alters the surface characteristics of the substrate so as to render such surface hydrophilic and, conversely, depositing polymerizable surfactant in a non-polar solvent on a substrate which is a hydrophilic or has been coated with a polymerized surfactant to render the substrate hydrophilic alters the surface characteristics of the substrate so as to render such surface hydrophobic.

In preferred embodiments of the method of the invention, if the substrate surface to be coated is a hydrophobic solid material, then the polymerizable surfactant is deposited in the absence of a non-polar solvent. If the surface of the solid material is hydrophilic or the surface already has an initial coating of polymerizable surfactant thereon which has been applied in the absence of a non-polar solvent to render the surface hydrophilic, then the polymerizable surfactant is deposited on the surface in a non-polar solvent.

The methods and procedures of the invention permit modification and alteration of characteristics of the substrate surfaces or layers thereon to either change the inherent nature of the surface, such as by changing a hydrophobic surface to a hydrophilic one, or by altering the degree of hydrophilicity or hydrophobicity of a surface.

As noted above, layers of polymerized surfactant may be assembled on one or more, but less than all, of the the surfaces of the substrate, all surfaces of the substrate, and/or on one or more partial surfaces of the substrate as is desired for the intended application of such modified substrate.

The number of layers of polymerized surfactant which may be assembled upon the substrate is generally not limited to any particular number and assembly of up to five or six layers is practical. The number of layers which may be applied to the substrate depends upon the reaction conditions and parameters as well as the type of substrates, solvents, and surfactants utilized as well as the method of

assembling the polymerized surfactant layers thereon such that the number of layers applied can differ to a great degree as will be known to one skilled in the art.

Successive coating layers are applied until a prescribed structural surface characteristic for the multistage assembly is attained. Generally, the polymerizable surfactant is applied and assembled in alternate layers having hydrophilic and a hydrophobic surface characteristics. Each layer may also have other surface characteristics which can be altered, such as wetting, weathering, adhesion, dye adsorption, friction, electrostatic charging, permeation and biocompatibility.

The method of the invention for assembling multilayers of polymerized surfactant upon the surface of solid substrates will be illustrated by the following examples. Appreciation for the method of the invention and the multilayered surfactant coated solid material produced thereby can be gained by review of the examples and the data listed in Table I which is provided below.

EXAMPLE 1

Step A

Commercial low-density polyethylene film, 0.0762 mm (3 mils) thick, (Petrothene NA 344-55; density of 920 kg/m$^3$ (0.920 g/cm$^3$); 2.0 melt index), was (1) cut into 2 x 100 mm (10 cm) pieces, (2) heated for 2 hours in refluxing 1:1 $CHCl_3$-$CH_3OH$, (3) extracted in a Soxhlet with $CHCl_3$ for 12 hours, and (4) dried [6 H, 78°C 13.3 Pa (0.1 mm)]. The resulting strips were each placed into separate 25 ml quartz test tubes, followed by addition of 20 ml of a vesicle dispersion of the phospholipid, bis [12-(methacryloyloxy)-dodecanoyl]-L-phosphatidylcholine (I). The vesicle dispersion was prepared by first dissolving 15 mg of (I) in 10 drops of $CHCl_3$ in a round-bottom flask and then coating the lipid onto the walls of the flask by evaporating off the solvent. For this, a stream of nitrogen was used initially, followed by drying under vacuum, which took 12 hours at room temperature, and 13.3 Pa (0.1mm). Distiled water (40 ml) was then added and the mixture was hand shaken for 5 minutes, degassed with nitrogen for 10 minutes, and subject to sonication in a bath type sonicator until constant turbidity was obtained. Typically, this required about 1 hour of sonication at 55°C.

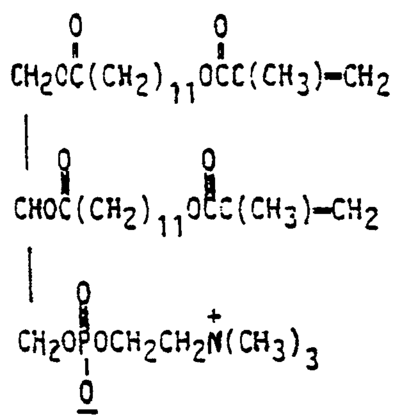

(I)

Each tube was purged with nitrogen for 10 minutes, sealed with a No-Air stopper, placed in a Rayonet photochemical reactor, and irradiated for 1 hour (2537A). The films were then removed from the tubes, gently hand shaken in air for about 15 seconds, and washed by immersing them into distilled water (about 100mL) and gently agitating them (each film was moved in and out of the wash six or seven times). The washing procedure was repeated four times using, in each case, freshly distilled water. Finally, each strip was immersed in 1:1 $CHCl_3$-$CH_3OH$ for 24 hours at room temperature and a coated strip (PE/I) was formed.

Step b

The strip of (PE/I) was then immersed in 21 mL of 100:1 n-hexadecane--chloroform containing 2.1 mg of (I), irradiated for 1 hour (2537A under a nitrogen atmosphere), immersed in 1:1 $CHCl_3$--$CH_3OH$ for 30

minutes at room temperature, rinsed with $CH_3OH$ and dried in air for 30 minutes to form a coated strip (PE/I/I).

Step c

The film strip (PE/I/I) was then treated with an aqueous dispersion of (I) as previously described, for Step (a) to give (PE/I/I/I).

Example 2

The procedure for Example 1 was followed except that the phospholipid (phosphatidylcholine) Compound (II) was substituted for (I).

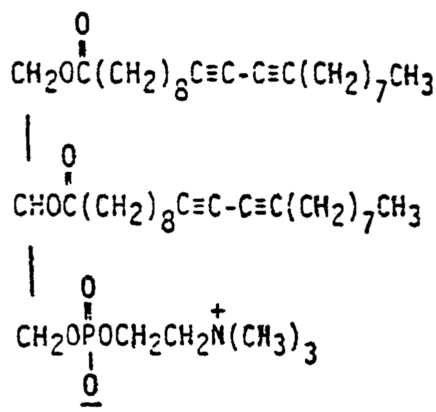

(II)

The procedure followed for this example thus produced strips of (PE/II); (PE/II/II); and (PE/II/II/II) after Steps (a), (b) and (c), respectively.

Table I provides an analysis for the resultant products of Examples 1 and 2.

Table I

Phospholipid Modified Film[a]

| film | $10^{18}$ lipids per $m^2$ ($10^{14}$ lipids[b] per $cm^2$) | Monolayer equivalent | Stationary contact angle for water (degrees) |
|---|---|---|---|
| Control | | | |
| PE | --- | --- | 100 |
| PE/I | 2.0 | 1.0 | 55 |
| PE/I/I | 3.2 | 1.6 | 79 |
| PE/I/I/I | 5.8 | 2.9 | 43 |
| Example 2 | | | |
| PE/II | 1.5 | 1.0 | 48 |
| PE/II/II | 3.1 | 2.1 | 68 |
| PE/II/II/II | 4.9 | 3.3 | 55 |

[a] Data listed are average values for four sepatate preparations. [b] Lipid content is based on the geometrical surface of PE.

Table I summarizes the loadings of phospholipids (I) and (II) on polyethylene film (PE) as determined by phosphorus analysis. The phosphorus analysis was carried out according to the procedure described at footnote 17 in Regen. S.L., Kirszensztejn, P., Singh, A., Macromolecules, 1983. Vol 16, pages 335-338. Stationary contact angles were measured for water at each stage of syntheses. If the cross-sectional area of (I) and (II) is estimated to be 0.7 $nm^2$ (70 $Å^2$), the maximum packing density of these lipids in a monolayer is 1.4 x $10^{18}$ lipids/$m^2$ (1.4 x $10^{14}$ lipids/$cm^2$). It is presumed that the higher loadings found for PE/I and PE/II reflect the fact that the true surface area exceeds the geometrical area, i.e., the film is not perfectly flat. A "monolayer equivalent" for polymerized (I) of PE is defined as 2.0 x $10^{18}$ lipids/$m^2$ (2.0 x $10^{14}$ lipids/$cm^2$), and 1.5 x $10^{18}$ lipids/$m^2$ (1.5 x $10^{14}$ lipids/$cm^2$) for (II). These values are then used to judge the completeness and uniformity of subsequent layers. As shown in Table I, successive treatment of PE/I with (I) in n-hexadecane--chloroform and in water leads to an additional lipid content approximating second and third layers. While a clear alteration in hydrophilicity is observed, both the specific lipid content and the observed contact angles indicate nonuniformity within the multilayer assembly (Note that PE/I, PE/I/I/I/, PE/II and PE/II/II/II are very hydrophilic; PE/I/I and PE/II/II are much more hydrophobic). These results, nonetheless, provide very strong support for the existence of polymerized and oriented monolayers of phosphatidylcholine attached to the surface of the PE.

Example 3

The procedure for Example 1 may be followed except that the phosphate ester (III) is substituted for (I).

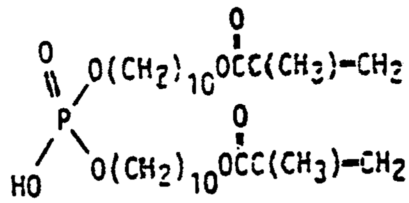

(III)

The process followed for this example will thus produce strips of (PE/III); (PE/III/III); and (PE/III/III/III) after Steps (a), (b) and (c), respectively.

Example 4

The procedure for Example 1 may be followed except that the phosphate ester (IV) is substituted for (I).

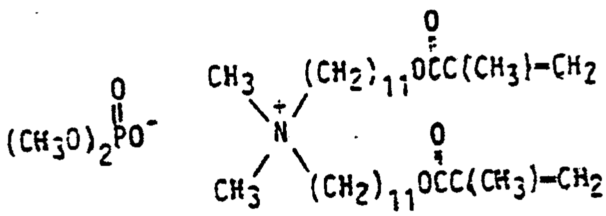

(IV)

The procedure followed for this example will thus produce strips of (PE/IV); (PE/IV/IV); and (PE/IV/IV/IV) after Steps (a), (b) and (c), respectively.

Monolayers formed following Step (a) of Examples 3 and 4, i.e., PE/III and PE/IV reached maximum loading using surfactant concentrations of 0.1 mg of (III) per ml and 0.4 mg of (IV) per ml, and were 3.6 x $10^{18}$ and 1.3 x $10^{18}$ lipids per $m^2$ (3.6 x $10^{14}$ and 1.3 x $10^{14}$ lipids per $cm^2$), respectively. The maximum loadings for I and II on PE were 2.0 x $10^{18}$ and 1.5 x $10^{18}$ lipids per $m^2$ (2.0 x $10^{14}$ and 1.5 x $10^{14}$ lipids per $cm^2$), respectively. Stationary contact angles for water on the surface of PE/I, PE/II, PE/III and PE/IV were 35°, 46°, 60° and 51°, respectively, indicating relatively hydrophilic surfaces; untreated PE showed a contact angle of 100°. Placement of water droplets at different locations on each film modified by I, II, III and IV indicated that the surfaces were uniformly wetted.

Comparative Example A

The procedure for Example 1 Step (a) was followed except that the phospholipid (A) was substituted for (I)

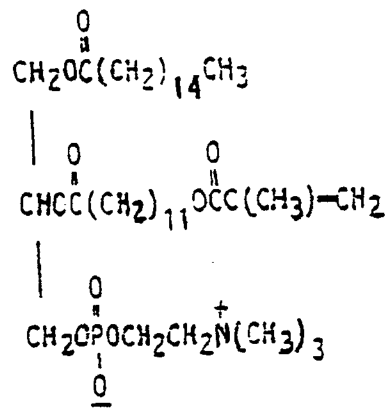

(A)

Phospholipid (A) did not form a monolayer on the polyethylene after Step (a) and failed to modify the polyethylene film as indicated by phosphorous analysis and by retention of the hydrophobic surface.

Comparative Example B

The procedure for Example Step (b) was followed except that the phospholipid (B) was substituted for (I)

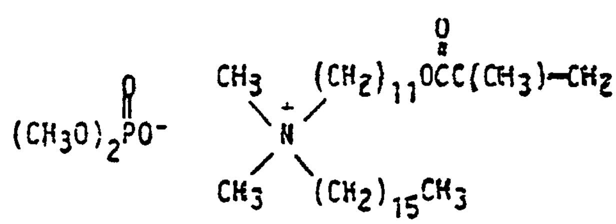

(B)

Phospholipid (B) did not form a monolayer on the polyethylene after Step (b) and failed to modify the polyethylene film as indicated by phosphorous analysis and by retention of the hydrophobic surface.

Example 5

The procedure for Example 1 may be followed except that the phospholipid (phosphatidylcholine) compound (II) is substituted for (I) in Step (b) only.

The procedure followed for this example will thus produce strips of (PE/I); (PE/I/II); and (PE/I/II/I) for Steps (a), (b) and (c), respectively.

The scope of the present invention is not limited by the description, examples and suggested uses herein, and modifications can be made without departing from the spirit of the invention. For example, the method of the invention can be carried out in a continuous manner utilizing a continuous substrate film to which layers according to the invention are assembled thereon. The term sonicate as used herein means to expose to high frequency sound waves, i.e., at a frequency of ≧ 20000 Hz.

**Claims**

**1.** A method for the stepwise coating of a solid substrate with a polyfunctional polymerizable surfactant to provide a multilayer assembly on a surface of the solid substrate comprising depositing and polymerizing sequential layers of polymerizable surfactant on said substrate or coated substrate from a

polymerization system comprising:

a) a polyfunctional polymerizable surfactant in an aqueous or polar solvent system; and

b) a polyfunctional polymerizable surfactant in non-polar organic solvent system;

wherein the sequential coatings are alternately effected from the (a) and (b) polymerization systems and the polymerizable surfactant utilized is the same or different for each sequential coating.

2. The method of Claim 1 wherein the surface of the substrate is substantially hydrophobic and the sytem (a) is utilized for the initial coating to form an alternate hydrophilic surface.

3. The method of Claim 1 wherein the substrate is substantially hydrophilic and polymerization system (b) is utilized for the initial coating to form an alternate hydrophobic surface.

4. The method of any of Claims 1 to 3 wherein the substrate is a solid organic polymer.

5. The method of Claim 4 wherein the substrate is a solid organic polymer selected from polyethylene, polypropylene, polybutylene, polystyrene, copolymers of ethylene or one or more $C_3$ to $C_8$ olefin monomers and mixtures of said polymers.

6. The method of Claim 4 wherein the solid organic polymer substrate is a film.

7. The method of any of Claims 1 to 6 wherein at least one surfactant is a phospholipid selected from phosphatidyl cholines, phosphate esters, or ammonium phosphates having at least two polymerizable groups present in separate acid moieties of said phospholipid.

8. The method of any of Claims 1 to 7 wherein said layers provide alternate hydrophilic and hydrophobic surface characteristics to the substrate.

9. A method as in Claim 1 for the stepwise coating of a hydrophobic solid substate with a polyfunctional polymerizable surfactant to provide a multilayer assembly on a surface of the hydrophobic solid substrate comprising the steps of:

a) depositing a polyfunctional polymerizable surfactant in an aqueous solution on a surface or a coated surface of the hydrophobic solid substrate;

b) polymerizing the surfactant deposited in step (a) to form a coating comprising a hydrophilic layer of polymerized surfactant on the surface of the solid substrate;

c) depositing a polyfunctional polymerizable surfactant in a non-polar solvent system on the coated hydrophilic surface of the solid substrate of step (b) wherein said surfactant may be the same or different from the surfactant of step (a); and

d) polymerizing the surfactant deposited in step (c) to form an additional coating on the substrate comprising a hydrophobic layer of polymerized surfactant on the surface of the solid substrate.

10. The method of Claim 9 wherein the hydrophobic solid substrate is an organic polymer film.

11. The method of any of Claims 1 to 3 wherein the substrate is glass, silanated glass, metal or graphite.

12. The multilayer surfactant coated solid substrate produced by the method of any of Claims 1 to 11.

13. A multilayered surfactant coated solid substrate prepared as in any of Claims 1 to 11 having a patterned coating of polymerized surfactant thereon.

14. A multilayered surfactant coated solid substrate as in Claim 13 in which said patterned coating is in the form of a photoresist.

15. An isolated surfaced article having deposited on some or all of the isolated surfaces thereof a multilayer assembly formed from a plurality of polymerized oriented mono layers of polymerizable surfactant wherein said isolated surfaced article has irregular or complexed shaped surfaces.

16. An isolated surfaced article as in Claim 15 which is porous or non-porous and in the form of a tube,

and/or has a webbed surface, and/or has a woven or non-woven construction and/or is a fine particulated sized material and/or is a rough surfaced material.

**17.** An isolated surfaced article as in Claim 15 having a patterned coating of polymerized surfactant thereon.

**18.** An isolated surfaced article as in Claim 17 in which said patterned coating is in the form of a photoresist.

**19.** An isolated surfaced article as in Claim 17 in which a patterned coating is applied to a non-linear optical element.

**20.** A substrate having directly deposited thereon a multilayer assembly formed from a plurality of oriented monolayers of polymerized surfactant, said multilayer assembly being obtainable by a method as claimed in claim 1.

**21.** A substrate as in Claim 20 which is planar.

**22.** A substrate as in Claim 20 which has one or more isolated surfaces.

**23.** A substrate as in Claim 20 having a patterned coating of polymerized surfactant applied thereto.

**24.** A substrate as in Claim 23 in which said patterned coating is in the form of a photoresist.

**25.** A substrate as in Claim 23 in which said patterned coating is applied to a non-linear optical element.

**26.** A substrate as claimed in any of claims 20 to 25 in which the thickness of each coating is 2 to 5 nm.

**27.** A substrate as claimed in any of claims 20 to 26 wherein said multilayer assembly comprises alternate layers having hydrophobic and hydrophilic characteristics respectively.

**28.** A substrate as claimed in any of claims 20 to 27 wherein said multilayer assembly has up to 6 monolayers.

**Revendications**

**1.** Procédé pour le revêtement par étapes d'un substrat solide par un agent tensio-actif polymérisable polyfonctionnel pour fournir un ensemble multicouche sur une surface du substrat solide, comprenant le dépôt et la polymérisation de couches successives d'agent tensio-actif polymérisable sur ledit substrat ou ledit substrat revêtu à partir d'un système de polymérisation comprenant :

a) un agent tensio-actif polymérisable polyfonctionnel dans un système solvant aqueux ou polaire ; et

b) un agent tensio-actif polymérisable polyfonctionnel dans un système solvant organique non-polaire ;

dans lequel les revêtements successifs sont effectués en alternance à partir des systèmes de polymérisation (a) et (b) et l'agent tensio-actif polymérisable utilisé est le même ou différent pour chacun des revêtements successifs.

**2.** Procédé selon la revendication 1, dans lequel la surface du substrat est substantiellement hydrophobe et le système (a) est utilisé pour le revêtement initial afin de former une surface hydrophile alternante.

**3.** Procédé selon la revendication 1, dans lequel le substrat est substantiellement hydrophile et le système de polymérisation (b) est utilisé pour le revêtement initial afin de former une surface hydrophobe alternante.

**4.** Procédé selon l'une quelconque des revendications 1 à 3, dans lequel le substrat est un polymère organique solide.

5. Procédé selon la revendication 4, dans lequel le substrat est un polymère organique solide choisi parmi le polyéthylène, le polypropylène, le polybutylène, le polystyrène, les copolymères de l'éthylène ou d'un ou plusieurs monomères oléfiniques $C_3$ à $C_8$, et les mélanges desdits polymères.

6. Procédé selon la revendication 4, dans lequel le substrat polymère organique solide est un film.

7. Procédé selon l'une quelconque des revendications 1 à 6, dans lequel au moins l'un des agents tensio-actifs est un phospholipide choisi parmi les phosphatidyl cholines, les esters phosphates, ou les phosphates d'ammonium ayant au moins deux groupes polymérisables présents dans des fractions acides séparées dudit phospholipide.

8. Procédé selon l'une quelconque des revendications 1 à 7, dans lequel lesdites couches confèrent au substrat des caractéristiques de surface hydrophile et hydrophobe alternantes.

9. Procédé selon la revendication 1, pour le revêtement par étapes d'un substrat solide hydrophobe par un agent tensio-actif polymérisable polyfonctionnel, pour fournir un ensemble multicouche sur une surface du substrat solide hydrophobe, comprenant les étapes consistant à :
   a) déposer un agent tensio-actif polymérisable polyfonctionnel dans une solution aqueuse sur une surface ou une surface revêtue du substrat solide hydrophobe ;
   b) polymériser l'agent tensio-actif déposé à l'étape (a), pour former un revêtement comprenant une couche hydrophile d'agent tensio-actif polymérisé sur la surface du substrat solide ;
   c) déposer un agent tensio-actif polymérisable polyfonctionnel dans un système solvant non-polaire sur la surface hydrophile revêtue du substrat solide de l'étape (b), ledit agent tensio-actif pouvant être identique à ou différent de l'agent tensio-actif de l'étape (a) ; et
   d) polymériser l'agent tensio-actif déposé à l'étape (c), pour former un revêtement supplémentaire sur le substrat comprenant une couche hydrophobe d'agent tensio-actif polymérisé sur la surface du substrat solide.

10. Procédé selon la revendication 9, dans lequel le substrat solide hydrophobe est un film de polymère organique.

11. Procédé selon l'une quelconque des revendications 1 à 3, dans lequel le substrat est du verre, du verre silané, un métal ou du graphite.

12. Substrat solide à revêtement d'agent tensioactif multicouche obtenu par le procédé tel que défini à l'une quelconque des revendications 1 à 11.

13. Substrat solide à revêtement d'agent tensio-actif multicouche préparé comme défini à l'une quelconque des revendications 1 à 11, sur lequel se trouve un revêtement à motifs d'agent tensio-actif polymérisé.

14. Substrat solide à revêtement d'agent tensio-actif multicouche, selon la revendication 13, dans lequel ledit revêtement à motifs se présente sous la forme d'un agent photorésistant.

15. Article à surfaces isolées, sur lequel est déposé sur certaines ou sur la totalité de ses surfaces isolées un ensemble multicouche formé à partir d'une pluralité de monocouches orientées, polymérisées, d'agent tensio-actif polymérisable, ledit article à surfaces isolées ayant des surfaces de forme irrégulière ou complexe.

16. Article à surfaces isolées selon la revendication 15, qui est poreux ou non-poreux et se présente sous la forme d'un tube, et/ou présente une surface à nervures, et/ou présente une structure tissée ou non-tissée et/ou est une matière de dimension particulaire fine et/ou est une matière à surface rugueuse.

17. Article à surfaces isolées selon la revendication 15, sur lequel se trouve un revêtement à motifs d'agent tensio-actif polymérisé.

18. Article à surfaces isolées selon la revendication 17, dans lequel ledit revêtement à motifs se présente sous la forme d'un agent photorésistant.

19. Article à surfaces isolées selon la revendication 17, dans lequel un revêtement à motifs est appliqué sur un élément optique non-linéaire.

20. Substrat sur lequel a été déposé directement un ensemble multicouche formé à partir d'une pluralité de monocouches orientées d'agent tensio-actif polymérisé, ledit ensemble multicouche pouvant être obtenu par un procédé tel que défini à la revendication 1.

21. Substrat selon la revendication 20, qui est plan.

22. Substrat selon la revendication 20, qui présente une ou plusieurs surfaces isolées.

23. Substrat tel que défini à la revendication 20, sur lequel a été appliqué un revêtement à motifs d'agent tensio-actif polymérisé.

24. Substrat selon la revendication 23, dans lequel ledit revêtement à motifs se présente sous la forme d'un agent photorésistant.

25. Substrat selon la revendication 23, dans lequel ledit revêtement à motifs est appliqué sur un élément optique non-linéaire.

26. Substrat selon l'une quelconque des revendications 20 à 25, dans lequel l'épaisseur de chaque revêtement est de 2 à 5 nm.

27. Substrat selon l'une quelconque des revendications 20 à 26, dans lequel ledit ensemble multicouche comprend des couches alternantes ayant des caractéristiques respectivement hydrophobes et hydrophiles.

28. Substrat selon l'une quelconque des revendications 20 à 27, dans lequel ledit ensemble multicouche présente jusqu'à 6 monocouches.

**Patentansprüche**

1. Verfahren zum schrittweisen Überziehen eines festen Substrats mit einem polyfunktionellen polymerisierbaren Tensid zwecks Herstellung einer mehrschichtigen Anordnung auf einer Oberfläche des festen Substrats, wobei auf das Substrat oder das überzogene Substrat aufeinanderfolgende Schichten aus einem polymerisierbaren Tensid aufgetragen und darauf polymerisiert werden, das von einem der Polymerisationssysteme stammt, die aus
   a) einem polyfunktionellen polymerisierbaren Tensid in einem wäßrigen oder polaren Lösungsmittelsystem; und
   b) einem polyfunktionellen polymerisierbaren Tensid in einem nichtpolaren organischen Lösungsmittelsystem bestehen,
   wobei für die aufeinanderfolgenden Überzüge abwechselnd die Polymerisationssysteme (a) und (b) verwendet werden und für jeden der aufeinanderfolgenden Überzüge gleiche oder verschiedene polymerisierbare Tenside verwendet werden.

2. Verfahren nach Anspruch 1, dadurch gekennzeichnet, daß die Oberfläche des Substrats im wesentlichen hydrophob ist und für den ersten Überzug das System (a) zur Bildung einer hydrophilen Oberfläche verwendet wird.

3. Verfahren nach Anspruch 1, dadurch gekennzeichnet, daß das Substrat im wesentlichen hydrophil ist und für den ersten Überzug das Polymerisationssystem (b) unter Bildung einer hydrophoben Oberfläche verwendet wird.

4. Verfahren nach einem der Ansprüche 1 bis 3, dadurch gekennzeichnet, daß das Substrat ein festes organisches Polymer ist.

5. Verfahren nach Anspruch 4, dadurch gekennzeichnet, daß das Substrat ein festes organisches Polymer ist, das aus dem Polyethylen, Polypropylen, Polybutylen, Polystyrol, den Copolymeren des Ethylens

oder einem oder mehreren $C_3$- bis $C_8$-Olefinmonomeren und Gemischen der genannten Polymere ausgewählt ist.

6. Verfahren nach Anspruch 4, dadurch gekennzeichnet, daß das feste organische Polymer eine Feinfolie ist.

7. Verfahren nach einem der Ansprüche 1 bis 6, dadurch gekennzeichnet, daß mindestens ein Tensid ein Phospholipid ist, das aus den Phosphatidylcholinen, Phosphatestern oder den Ammoniumphosphaten mit mindestens zwei in getrennten Säureanteilen des Phospholipids vorhandenen polymerisierbaren Gruppen ausgewählt ist.

8. Verfahren nach einem der Ansprüche 1 bis 7, dadurch gekennzeichnet, daß die genannten Schichten dem Substrat abwechselnd hydrophile und hydrophobe Oberflächeneigenschaften verleihen.

9. Verfahren nach Anspruch 1 zum schrittweisen Überziehen eines hydrophoben festen Substrats mit einem polyfunktionellen polymerisierbaren Tensid zwecks Herstellung einer mehrschichtigen Anordnung auf einer Oberfläche des hydrophoben festen Substrats, mit folgenden Schritten:
a) auf eine Oberfläche oder eine überzogene Oberfläche des hydrophoben festen Substrats wird ein polyfunktionelles polymerisierbares Tensid in wäßriger Lösung aufgetragen,
b) durch Polymerisieren des im Schritt (a) aufgetragenen Tensids wird ein Überzug gebildet, der wenigstens teilweise aus einer hydrophilen Schicht aus polymerisiertem Tensid auf der Oberfläche des festen Substrats besteht;
c) auf die im Schritt (b) gebildete, hydrophile Oberfläche des festen Substrats wird ein polyfunktionelles polymerisierbares Tensid in einem nichtpolaren Lösungsmittelsystem aufgetragen, wobei dieses Tensid das gleiche Tensid wie das im Schritt (a) verwendete oder ein anderes Tensid sein kann;
d) durch Polymerisieren des im Schritt (c) aufgetragenen Tensids wird auf dem Substrat ein zusätzlicher Überzug aufgetragen, der wenigstens teilweise aus einer hydrophoben Schicht aus polymerisiertem Tensid auf der Oberfläche des festen Substrats besteht.

10. Verfahren nach Anspruch 9, dadurch gekennzeichnet, daß das hydrophobe feste Substrat eine Feinfolie aus einem organischen Polymer ist.

11. Verfahren nach einem der Ansprüche 1 bis 3, dadurch gekennzeichnet, daß das Substrat Glas, silaniertes Glas, Metall oder Graphit ist.

12. Mit einer Mehrzahl von Tensidschichten überzogenes festes Substrat, das nach dem Verfahren eines der Ansprüche 1 bis 11 hergestellt ist.

13. Mit einer Mehrzahl von Tensidschichten überzogenes festes Substrat, das nach dem Verfahren eines der Ansprüche 1 bis 11 hergestellt und das mit einem gemusterten Überzug aus polymerisiertem Tensid versehen ist.

14. Mit einer Mehrzahl von Tensidschichten überzogenes festes Substrat nach Anspruch 13, dadurch gekennzeichnet, daß der gemusterte Überzug ein Photolack ist.

15. Gegenstand mit abgesonderten Flächen, der auf einigen oder allen seiner abgesonderten Flächen mit einer mehrschichtigen Anordnung aus einer Mehrzahl von polymerisierten orientierten monomolekularen Schichten aus polymerisierbarem Tensid versehen ist, wobei der abgesonderte Flächen aufweisende Gegenstand unregelmäßige oder kompliziert geformte Flächen besitzt.

16. Gegenstand mit abgesonderten Flächen nach Anspruch 15, der porös oder nichtporös ist und die Form eines Rohres hat und/oder eine gerippte Oberfläche hat und/oder ein Gewebe oder ein Vliesstoff ist und/oder eine feinteilige Substanz ist und/oder ein Gegenstand mit einer rauhen Oberfläche ist.

17. Gegenstand mit abgesonderten Flächen nach Anspruch 15 mit einem gemusterten Überzug aus polymerisiertem Tensid.

**18.** Gegenstand mit abgesonderten Flächen nach Anspruch 17, dadurch gekennzeichnet, daß der gemusterte Überzug ein Photolack ist.

**19.** Gegenstand mit abgesonderten Flächen nach Anspruch 17 mit einem auf ein nichtlineares optisches Element aufgetragenen, gemusterten Überzug.

**20.** Substrat, auf dem direkt eine mehrschichtige Anordnung aufgetragen ist, die aus einer Mehrzahl von orientierten monomolekularen Schichten aus polymerisiertem Tensid besteht und die nach einem Verfahren nach Anspruch 1 herstellbar ist.

**21.** Substrat nach Anspruch 20, das ebenflächig ist.

**22.** Substrat nach Anspruch 20, das eine oder mehrere abgesonderte Flächen hat.

**23.** Substrat nach Anspruch 20, das einen darauf aufgetragenen gemusterten Überzug aus polymerisiertem Tensid besitzt.

**24.** Substrat nach Anspruch 23, dadurch gekennzeichnet, daß der gemusterte Überzug ein Photolack ist.

**25.** Substrat nach Anspruch 23, dadurch gekennzeichnet, daß der gemusterte Überzug euf einem nichtlinearen optischen Element vorgesehen ist.

**26.** Substrat nach einem der Ansprüche 20 bis 25, dadurch gekennzeichnet, daß jede Schicht eine Dicke von 2 bis 5 nm hat.

**27.** Substrat nach einem der Ansprüche 20 bis 26, dadurch gekennzeichnet, daß die mehrschichtige Anordnung abwechselnd aus Schichten mit hydrophoben und hydrophilen Eigenschaften besteht.

**28.** Substrat nach einem der Ansprüche 20 bis 27, dadurch gekennzeichnet, daß die mehrschichtige Anordnung bis zu 6 monomolekulare Schichten enthält.